# EUROPÄISCHE PATENTSCHRIFT

(11) **EP 2 526 154 B1**
(45) Veröffentlichungstag und Bekanntmachung des Hinweises auf die Patenterteilung: **21.11.2018**
(21) Anmeldenummer: 11704420.6
(22) Anmeldetag: 19.01.2011
(51) Int. Cl.: C09D 4/00

(54) **Verfahren zur optischen Lithographie unterhalb des Beugungslimits**
Method for optical lithography below the diffraction limit
Procédé de lithographie optique en dessous de la limite de diffraction

(30) Priorität: 22.01.2010 DE 102010000169
(43) Veröffentlichungstag der Anmeldung: 28.11.2012
(73) Patentinhaber: Karlsruher Institut für Technologie, 76131 Karlsruhe (DE)
(72) Erfinder: FISCHER, Joachim, 76131 Karlsruhe (DE); VON FREYMANN, Georg, 67657 Kaiserslautern (DE); WEGENER, Martin, 76227 Karlsruhe (DE)
(74) Vertreter: Fitzner, Uwe
(86) Internationale Anmeldenummer: PCT/EP2011/050692
(87) Internationale Veröffentlichungsnummer: WO 2011/089157

(56) Entgegenhaltungen:
- DE-A1- 3 248 246
- FR-A1- 2 735 718
- US-A- 5 153 236
- US-A- 5 777 342
- US-A1- 2003 139 484
- LINJIE LI ET AL.: "Achieving Lambda/20 Resolution by One-Color Initiation and Deactivation of Polymerization", SCIENCE, Bd. 324, 15. Mai 2009 (2009-05-15), Seiten 910-913, XP002648116, DOI: 10.1126/science.1168996 in der Anmeldung erwähnt

## Beschreibung

Die vorliegende Anmeldung nimmt die Priorität der DE 10 2010 000 169.4 in Anspruch.

Die vorliegende Erfindung betrifft ein Verfahren zur optischen Lithographie unterhalb des Beugungslimits und die Verwendung bestimmter Photoinitiatoren zum Erzeugen lithographischer Strukturen unterhalb des Beugungslimits.

### Stand der Technik:

Wie beispielsweise aus der DE 103 25 459 A1 bekannt, kann das Beugungslimit umgangen werden, indem man sich einen sättigbaren optischen Übergang zunutze macht. DE 103 25 459 A1 skizziert die Möglichkeit, analog zur STED-Mikroskopie sehr kleine Strukturen lithographisch zu erzeugen. Allerdings ist hier konkrete experimentelle Umsetzung beschrieben. Eine ähnliche Offenbarung findet sich in S. W. Hell, Strategy for far-field optical imaging and writing without diffraction limit, Physics Letters A 326 (2004) 140-145.

Timothy F. Scott et al. haben in der Zeitschrift "Science" im Mai 2009 im Artikel "Two-Color Single-Photon Photoinitiation and Photoinhibition for Subdiffraction Photolithography" ein vergleichbares Verfahren vorgestellt. Hier wurde dem Fotolack neben dem Photoinitiator eine weitere photoaktivierbare Substanz beigegeben, die nach der Aktivierung lokal die Polymerisationsrate verringert. Es ist fraglich, ob mit dem beschriebenen Verfahren auch dreidimensionale Strukturen hergestellt werden können. Die Substanz, die die Polymerisationsrate verringert, absorbiert das Abregungslicht, egal ob eine lokale Anregung vorliegt oder nicht, deshalb kann das Abregungslicht nicht tief in die Probe eindringen.
Linjie Li et al. haben in der Zeitschrift "Science" im Mai 2009 im Artikel "Achieving Lambda/20 Resolution by One-Color Initiation and Deactivation of Polymerization" ebenfalls ein vergleichbares Verfahren vorgestellt. Hier wird kein kommerzieller etablierter Photoinitiator, sondern ein zweckentfremdeter Farbstoff (Malachitgrün) als Photoinitiator verwendet. Im Supporting Online Material zu dieser Veröffentlichung ist jedoch beschrieben, dass andere Stoffe, wie Brilliantgrün oder auch einige übliche kommerzielle Photoinitiatoren (z.B. Isopropylthioxanthon) nicht photodeaktivierbar sind. In diesem Dokument wird ein Laser verwendet, dessen Wellenlängenbereich 700 bis 1000 nm beträgt.

Eine photosensitive Substanz wie z.B. ein Fotolack bestehen i.d.R. aus mindestens einer zu vernetzenden Substanz (z.B. einem Monomer) und einem Photoinitiator, der Licht absorbiert und die Vernetzungsreaktion startet.

Weiterer technologischer Hintergrund wird beispielsweise in US 5,777,342, US 2003/139484 A1, US 5,153,236, DE 32 48 246 A1 oder FR 2 735 718 A beschrieben.

### Aufgabe:

Aufgabe der vorliegenden Erfindung war es, ein Verfahren zur optischen Lithographie unterhalb des Beugungslimits, sowie dafür geeignete Lacke und Initiatoren/Initiatorsysteme zur Verfügung zu stellen.

Weiter war es Aufgabe der vorliegenden Erfindung neue Verwendungen für Thioxanthone, Cumarine und bestimmte Benzophenone zu finden.

### Lösung:

Diese Aufgabe wird durch ein Verfahren zur optischen Lithographie unterhalb des Beugungslimits bei dem
a) ein Lack enthaltend oder bestehend aus
   (i) mindestens einem polymerisierbaren Monomer,
   (ii) mindestens einem photodeaktiverbaren Photoinitiator,
   (iia) gegebenenfalls mindestens einen Co-Initiator (iii) gegebenenfalls ein Lösemittel oder Lösemittelgemisch,
   (iv) gegebenenfalls weiteren Hilfsstoffen,
   auf ein Substrat aufgebracht wird,
b) die Polymerisation durch Einstrahlung von Licht, bevorzugt eines Lasers, einer ersten, den Photoinitiator aktivierenden, Wellenlänge an einem ausgewählten Ort initiiert wird, und gleichzeitig oder danach
c) die Polymerisation durch Einstrahlung von Licht, bevorzugt eines Lasers, einer zweiten, den Photoinitiator deaktivierenden, Wellenlänge in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt, dadurch gekennzeichnet, dass
als photodeaktivierbare Photoinitiatoren Thioxanthone und/oder Cumarine und/oder bis-(Di-N-alkylierte) Aminobenzophenone eingesetzt werden,
die Verwendung von Thioxanthonen und/oder Cumarinen und/oder bis-alkylierte Aminobenzophenone als photodeaktivierbare Photoinitiatoren, in vorgenanntem Verfahren und in einem Verfahren zur Verkleinerung des Lithographiemaßstabs, sowie einen Lithographielack bestehend aus Monomeren und Thioxanthonen und/oder Cumarinen und/oder bis-(Di-N-alkylierten) Aminobenzophenonen gelöst.

Weiterhin wird die Aufgabe gelöst durch ein Verfahren zur optischen Lithographie unterhalb des Beugungslimits bei dem
a) ein optischer Formkörper bereitgestellt wird,
b) die Polymerisation durch Einstrahlung von Licht, bevorzugt eines Lasers, einer ersten, den Photoinitiator aktivierenden, Wellenlänge an einem ausgewählten Ort initiiert wird, und gleichzeitig oder danach
c) die Polymerisation durch Einstrahlung von Licht, bevorzugt eines Lasers, einer zweiten, den Photoinitiator deaktivierenden, Wellenlänge in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt, dadurch gekennzeichnet, dass
als photodeaktivierbare Photoinitiatoren Thioxanthone und/oder Cumarine und/oder bis-(Di-N-alkylierte) Aminobenzophenone eingesetzt werden.

### Begriffsdefinitionen:

Im Rahmen der vorliegenden Erfindung sind alle Mengenangaben, sofern nicht anders angegeben, als Gewichtsangaben zu verstehen.

Im Rahmen der vorliegenden Erfindung bedeutet der Begriff "Zimmertemperatur" eine Temperatur von 20°C. Temperaturangaben sind, soweit nicht anders angegeben, in Grad Celsius (°C).

Sofern nichts anderes angegeben wird, werden die angeführten Reaktionen bzw. Verfahrensschritte bei Normaldruck/Atmosphärendruck, d.h. bei 1013 mbar, durchgeführt.

Im Rahmen der vorliegenden Erfindung werden unter dem Begriff "Photoinitiator" Stoffe verstanden, die bei Bestrahlung mit Licht durch Zerfall eine radikalische oder kationische Polymerisation initiieren können, gegebenenfalls unter Zuhilfenahme von Co-Initiatoren.

Der Ausdruck (Meth)acryl soll im Rahmen der vorliegenden Erfindung sowohl Methacryl als auch Acryl bzw. Mischungen beider umfassen.

Im Rahmen der vorliegenden Erfindung umfasst der Begriff "ITX" alle Stellungsisomere von Isopropylthioxanthon, sofern nicht anders angegeben.

Der Begriff "Lithographie" umfasst im Rahmen der vorliegenden Erfindung je nach Zusammenhang lithographische Verfahren oder lithographisch erzeugte Strukturen.

Der Begriff "Monomer" bedeutet im Rahmen der vorliegenden Erfindung einzelne polymerisierbare Einheiten und umfasst auch Oligomere und/oder Prepolymere.

Im Rahmen der vorliegende Erfindung bedeutet der Begriff "optischer Formkörper" Polymer-Matrices, die nicht vollständig vernetzt sind und in denen durch Lichteinstrahlung Bereiche vollständig oder zumindest stärker vernetzt werden können und somit der Brechungsindex der Bereiche verändert werden kann.

### Detaillierte Beschreibung:

Wie alle optischen Technologien ist die optische Lithographie in ihrer Auflösung grundsätzlich begrenzt, da Licht einer gewissen Frequenz nicht beliebig hart, sondern nur auf ca. eine halbe Wellenlänge fokussiert werden kann. Diese Restriktion wird allgemein als das Beugungslimit bezeichnet und begrenzt die räumliche Auflösung, die man bei Lithographie mit fokussiertem Licht erreichen kann. Durch Ausnutzung einer optischen Nichtlinearität (z.B. Mehrphotonenabsorption) kann die Strukturgröße in begrenztem Maße unter diese Schwelle gedrückt werden (z.B. um einen Faktor von 2^{½} für Zweiphotonenabsorption). Auch eine chemische Nichtlinearität (z.B. eine scharfe Polymerisationsschwelle) ermöglicht es kleinere Strukturen zu erzeugen, jedoch auf Kosten von Reproduzierbarkeit und Strukturstabilität.

Die vorliegende Erfindung ermöglicht dieses Beugungslimit praktisch zu umgehen. So kann beispielsweise in eine Fotolackschicht optisch eine räumlich enger begrenzte Anregung eingebracht werden, als das mit einer herkömmlichen optischen Belichtung möglich wäre und somit kleinere Strukturen hergestellt werden.

Zur Anregung kann sowohl Ein- als auch Mehrphotonenabsorption eingesetzt werden. Die räumliche Verengung der Anregung ist dabei von der Anregungsart unabhängig.

Das Verfahren zur optischen Lithographie unterhalb des Beugungslimits gemäß vorliegender Erfindung umfasst die folgenden Schritte:
a) ein Lack enthaltend oder bestehend aus
   (i) mindestens einem polymerisierbaren Monomeren,
   (ii) mindestens einem photodeaktiverbaren Photoinitiator,
   (iia) gegebenenfalls mindestens einen Co-Initiator (iii) gegebenenfalls ein Lösemittel oder Lösemittelgemisch,
   (iv) gegebenenfalls weiteren Hilfsstoffen,
   wird auf ein Substrat aufgebracht,
b) die Polymerisation wird durch Einstrahlung von Licht, bevorzugt eines Lasers, einer ersten, den Photoinitiator aktivierenden, Wellenlänge an einem ausgewählten Ort initiiert, und gleichzeitig oder danach
c) die Polymerisation wird durch Einstrahlung von Licht, bevorzugt eines Lasers, einer zweiten, den Photoinitiator deaktivierenden, Wellenlänge in der unmittelbaren Umgebung des ausgewählten Ortes unterdrückt,
wobei
mit dem eingestrahlten Abregungslicht ein Interferenz-Muster erzeugt wird, welches an dem ausgewählten Ort ein Intensitätsminimum oder null Intensität besitzt, dadurch gekennzeichnet, dass
als photodeaktivierbare Photoinitiatoren Thioxanthone und/oder Cumarine und/oder bis-(Di-N-alkylierte) Aminobenzophenone eingesetzt werden.

Eine Variante der vorliegende Erfindung ist ein Verfahren zur optischen Lithographie unterhalb des Beugungslimits bei dem
a) ein optischer Formkörper bereitgestellt wird,
b) die Polymerisation durch Einstrahlung von Licht, bevorzugt eines Lasers, einer ersten, den Photoinitiator aktivierenden, Wellenlänge an einem ausgewählten Ort initiiert wird, und gleichzeitig oder danach
c) die Polymerisation durch Einstrahlung von Licht, bevorzugt eines Lasers, einer zweiten, den Photoinitiator deaktivierenden, Wellenlänge in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt, dadurch gekennzeichnet, dass
als photodeaktivierbare Photoinitiatoren Thioxanthone und/oder Cumarine und/oder bis-(Di-N-alkylierte) Aminobenzophenone eingesetzt werden.

Bei der vorliegenden Erfindung wird ein photodeaktivierbarer Photoinitiator benutzt, der durch Einstrahlung einer zweiten Wellenlänge deaktiviert werden kann, bevor er die chemische Reaktion startet. Dadurch wird die Vernetzungsreaktion lokal unterdrückt.

Dabei wird zusätzlich zur Anregung noch mit einem Abregungslicht ein Interferenz-Muster erzeugt, was an den Stellen, an denen sehr kleine Strukturen erzeugt werden sollen, ein Intensitätsminimum oder idealerweise null Intensität besitzt. So wird die Auswirkung der optisch eingebrachten Anregung lokal entsprechend der Abregungsintensität reduziert, bei großen Intensitäten stark, bei kleinen wenig, bei null Intensität überhaupt nicht. Folglich kann durch Vervielfachen der gesamten Abregungsleistung eine immer stärkere Verengung der übrig bleibenden Anregung um das lokale Minimum erreicht werden.

Bevorzugt werden im Rahmen der vorliegende Erfindung sowohl Anregung als auch Abregung durch Laser-Licht erzeugt.

Die erfindungsgemäß einsetzbaren photodeaktivierbaren Photoinitiatoren ermöglichen es in einem Fotolack oder einem holographischen Speicher zusammen mit der Benutzung eines zusätzlichen Lasers zum Abregen, kleinere Strukturen herzustellen, als dies mit konventionellen optischen Lithographietechniken bei vergleichbaren Wellenlängen und Aperturen möglich ist.

Bei dem erfindungsgemäßen Verfahren wird dabei mit dem zusätzlichen (Laser)-Licht um die zu belichtende Stelle herum ein Interferenzmuster erzeugt, das an dieser Stelle ein Intensitätsminimum (im Idealfall Intensität null) hat. Beim Belichtungsvorgang mit der ersten Lichtquelle wird dann entsprechend der lokalen Intensität der zusätzlichen Lichtquelle der Photoinitiator deaktiviert. Im Intensitätsminimum ist die Abregung am schwächsten, im Falle von null Intensität nicht vorhanden. Die verbleibende Anregung, die letztendlich zu einer Polymerisation führt, kann durch Erhöhen der Leistung des zweiten Lasers prinzipiell immer weiter eingeschränkt werden.

Durch die vorliegende Erfindung kann die Strukturgröße unabhängig von der Vernetzungsdichte eingestellt werden, was z.B. zu sehr kleinen und gleichzeitig stabilen Strukturen führen kann.

Im Rahmen der vorliegenden Erfindung werden solche Photoinitiatoren eingesetzt, die zum einen nach Lichteinstrahlung zerfallen und damit eine radikalische oder kationische Polymerisation initiieren können und die zum anderen nach Aktivierung durch Lichteinstrahlung durch Einstrahlung weiteren Lichts bestimmter Wellenlänge(n) photodeaktivierbar sind.

In einer Variante werden gegebenenfalls geeignete, fachübliche Co-Initiatoren zugesetzt, um die Photoinitiatoren bei der Initiierung der radikalischen Polymerisationen zu unterstützen, indem der Photoinitiator die Rolle der Lichtabsorption übernimmt, während der Co-Initiator dann für eine effizientere Initiierung sorgt.

In einer Variante werden gegebenenfalls geeignete Co-Initiatoren zugesetzt, die dann als Säuregeneratoren wirken, um eine kationische Polymerisationen zu starten.

Die genaue Auswahl der Co-Initiatoren ist abhängig von dem gewählten Photoinitiator und kann durch den Fachmann anhand seines allgemeinen Fachwissens, gegebenenfalls unter Zuhilfenahme einfacher Tabelle, ohne weiteres bewerkstelligt werden. Oft weisen die Hersteller/Verkäufer der Photoinitiatoren direkt (z.B. im Katalog oder auf der Verpackung) auf mögliche Co-Initiatoren für verschiedene Einsatzzwecke hin.

Eine bevorzugte Variante der vorliegenden Erfindung ist es für die Polymerisation keine Co-Initiatoren einzusetzen.

Erfindungsgemäß können als photodeaktivierbare Photoinitiatoren insbesondere Thioxanthone und/oder Cumarine und/oder bis-(Di-N-alkylierte) Aminobenzophenone eingesetzt werden.

Einsetzbare Thioxanthone sind beispielsweise - aber nicht ausschließlich - die durch die folgende Formel repräsentierten:

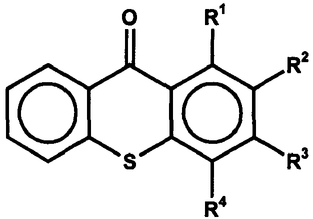

| Verbindung-Nr. | R¹ | R² | R³ | R⁴ |
|---|---|---|---|---|
| 1 | Hal | H | H | Isopropoxy |
| 2 | Hal | H | Isopropoxy | H |
| 3 | H | Hal | H | Isopropoxy |
| 4 | H | Hal | Isopropoxy | H |
| 5* | H | Isopropoxy | H | H |
| 6* | H | H | Isopropoxy | H |
| 7* | H | Isopropoxy | Isopropoxy | H |
| 8 | Hal | H | Isopropoxy | H |
| 9 | H | Hal | Isopropoxy | H |
| 10 | Hal | Hal | H | Isopropoxy |
| 11 | H | Isopropoxy | Hal | H |
| 12 | Isopropoxy | H | Hal | H |
| 13* | H | Cl | H | H |
| 14 | H | O-CH₂-CH(trimethylam ino⁺)-OH | Methyl | Methyl |
| 15 | H | H | O-(CH₂)₃-SO₃⁻ Na⁺ | H |
| 16 | Methyl | H | H | Propoxy |
| 17 | Methyl | H | H | O(CH₂)₃OCOC H=CH₂ |
| 18 | H | OCOCH3 | H | H |
| 19 | H | OCOCH=CH2 | H | H |
| 20 | H | Propoxy | H | H |
| 21 | H | O(CH₂)₃OCOC H=CH₂ | H | H |
| 22 | H | H | H | Propoxy |
| 23 | OH | H | H | H |
| 24 | H | OCH2Phenyl | H | H |
| 25 | H | Methyl | H | H |
| 26 | H | OH | H | H |
| 27* | H | H | H | H |
| 28* | H | OCOCH₃ | H | H |
| 29* | H | OCH2COOH | H | H |
| 30 | H | C₁₂H₂₅ | H | H |
| 31* | COOCH₃ | H | H | H |
| 32* | H | H | H | Isopropoxy |
| 33 | H | Isopropoxy | Isopropoxy | Isopropoxy |
| 34 | Isopropoxy | Isopropoxy | Isopropoxy | Isopropoxy |
| 35 | Isopropoxy | H | Isopropoxy | Isopropoxy |
| 36 | Isopropoxy | Isopropoxy | H | Isopropoxy |
| 37 | Isopropoxy | Isopropoxy | Isopropoxy | H |

| | | | | |
|---|---|---|---|---|
| Hal bedeutet jeweils Chlor, Brom, Iod oder Fluor | | | | |

Anstelle des Isopropoxy-Rests kann jeweils auch Ethoxy, Propoxy, n-Butoxy, i-Butoxy, t-Butoxy, n-Pentoxy, i-Pentoxy, Hexoxy, Cylcohexoxy stehen.

Von diesen Verbindungen sind die mit einem Stern (*) gekennzeichneten Verbindungen im Rahmen der vorliegenden Erfindung besonders bevorzugt. Eine weitere bevorzugte Verbindung ist das 2-Methyl-3'-COOC₂H₅-Thioxanthon.

In einer Variante der vorliegenden Erfindung werden die Thioxanthone ausgewählt aus der Gruppe bestehend aus den Verbindungen 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, den Ethoxy-, Propoxy-, n-Butoxy-, i-Butoxy-, t-Butoxy-, n-Pentoxy-, i-Pentoxy-, Hexoxy-, Cylcohexoxy-Derivaten der Isopropoxy-Verbindungen 1, 2, 3, 4, 5, 6, 7, 8, 9, 10, 11, 12, 2-Methyl-3'-COOC₂H₅-Thioxanthon und Mischungen davon.

In einer Variante der vorliegenden Erfindung werden die Thioxanthone ausgewählt aus der Gruppe bestehend aus den Verbindungen 5, 6, 7, 13, 27, 28, 29, 31, 32, 33, 34, 35, 36, 37 und Mischungen davon.

In einer Variante bevorzugte Thioxanthone sind dabei Thioxanthon, C₁-C₆-alkylierte Thioxanthone, bevorzugt C₁-C₆-alkylierte Thioxanthone, insbesondere 2-Isopropylthioxanthon, 4-Isopropylthioxanthon, 3-Isopropylthioxanthon oder Gemische davon.

Bevorzugte Cumarine werden ausgewählt aus der Gruppe bestehend aus Cumarin-1, Cumarin-2, Cumarin-4, Cumarin-6, Cumarin-7, Cumarin-10, Cumarin-30, Cumarin-102, Cumarin-106, Cumarin-120, Cumarin-138, Cumarin-151, Cumarin-152, Cumarin-175, Cumarin-307, Cumarin-311, Cumarin-314, Cumarin-334, Cumarin-337, Cumarin-346 und Mischungen davon, insbesondere Cumarin-30. Die vorliegende Erfindung ist jedoch nicht auf diese Cumarine beschränkt.

In einer Variante der vorliegende Erfindung ist es möglich, Mischungen von Thioxanthonen oder Mischungen von Cumarinen als photodeaktivierbare Photoinitiatoren einzusetzen.

In einer Variante der vorliegenden Erfindung können auch Mischungen von Thioxanthonen und Cumarinen, bevorzugt von ITX und Cumarin 30 als photodeaktivierbare Photoinitiatoren eingesetzt werden.

Es ist im Rahmen der vorliegenden Erfindung auch möglich bis-(Di-N-alkylierte) Aminobenzophenone, bevorzugt 4,4'-Bis-(Dimethylamino)benzophenon oder 4,4'-Bis-(Diethylamino)benzophenon, besonders bevorzugt 4,4'-Bis-(Diethylamino)benzophenon, als photodeaktivierbare Photoinitiatoren einzusetzen.

Im Rahmen der vorliegenden Erfindung konnte überraschenderweise abweichend von den Aussagen im Stand der Technik die Photodeaktivierbarkeit von Thioxanthonen und Cumarinen experimentell nachgewiesen werden.

Als Monomere werden für den Fotolack im Rahmen der vorliegenden Erfindung radikalische oder kationisch polymerisierbare Verbindungen, bevorzugt radikalisch polymerisierbare Verbindungen, insbesondere (Meth)acrylate und/oder andere vinylische Verbindungen eingesetzt.

In einer Variante der vorliegenden Erfindung werden als Monomere Pentaerythritoltriacrylat und/oder ethoxyliertes (9) Trimethylolpropantriacrylat eingesetzt, entweder allein oder in Kombination mit weiteren Monomeren. Weitere im Rahmen der vorliegenden Erfindung beispielsweise einsetzbare Monomere sind solche ausgewählt aus der Gruppe bestehend aus ethoxyliertem(6) Trimethylolpropantri(meth)acrylat, Tris(2-hydroxyethyl)isocyanurattri(meth)acrylat, Isocyanurat(meth)acrylat, Methyl(meth)acrylat, ethoxyliertes(2) Bisphenol-A-Di(meth)acrylat, Tetrahydropyranyl(meth)acrylat, Triethylenglycoldi(meth)acrylat, Isobornyl(meth)acrylat, Trimethylolpropantri(meth)acrylat, C₁-C₆-Alkyl(meth)acrylate und Gemischen davon, sowie gegebenenfalls Urethan(meth)acrylate, trifunktionelle (Meth)acrylate, alkoxylierte trifunktionelle (Meth)acrylate, bromierte Urethan(meth)acrylate, Urethanedi(meth)acrylate basierend auf Polyestern, aromatischen Urethan(meth)acrylaten.

Gut geeignet sind insbesondere auch Methyl(meth)acrylat, Ethyl(meth)acrylat, Propyl(meth)acrylat, Isopropyl(meth)acrylat, n-, iso-, t-Butylmethacrylat.

Als Lösemittel können im Rahmen der vorliegenden Erfindung prinzipiell alle bekannten Lösemittel eingesetzt werden, die die Lackbestandteile zu lösen vermögen und die nicht oder zumindest nur sehr gering in dem/den eingestrahlten Wellenlängenbereich(en) absorbieren.

Beispiele sind C₁- bis Ce-Alkohole inklusive Methanol, Ethanol, n- oder Isopropanol, n-Butanol, Cyclohexanol, Ketone inklusive Aceton, halogenierte Alkane inklusive Methylenchlorid, Chloroform, Ether inklusive Dimethylether, Diethylether, Tetrahydrofuran.

In einer Variante der vorliegenden Erfindung umfasst der Lack keine Lösemittel.

In einer Variante der vorliegenden Erfindung besteht der Lack aus polymerisierbaren Monomeren und photodeaktivierbaren Photoinitiator(en).

In einer Variante der vorliegenden Erfindung können als weitere Hilfsstoffe fachübliche und fachbekannte Stoffe wie oberflächenaktive Stoffe, Verlaufsmittel, Pigmente, Füllstoffe, Vernetzer, Stabilisatoren, Lichtschutzmittel (mit angepasstem Wellenlängenprofil) etc. eingesetzt werden.

Als Anregungslaser wird in einer Variante der vorliegende Erfindung ein Femtosekunden Titan:Saphir-Laser (140 Femtosekunden Pulsdauer, 80 Mhz Wiederholrate, Zentralwellenlänge zwischen 760 und 840 nm, insbesondere 810 nm Zentralwellenlänge) eingesetzt.

Als Abregungslaser werden in einer Variante der vorliegenden Erfindung Dauerstrichlaser (continuous wave, cw) einer Wellenlänge von 532 nm eingesetzt.

Die An- und Abregungslaser können unabhängig voneinander entweder beide gepulst, beide kontinuierlich oder der eine gepulst und der andere kontinuierlich betrieben werden.

Eine Variante der vorliegenden Erfindung ist es, das Anregungslicht gepulst und das Abregunglicht gepulst oder kontinuierlich (cw), bevorzugt kontinuierlich, einzustrahlen.

In einer Variante der vorliegende Erfindung hat der Abregungslaser eine Zentralwellenlänge zwischen 400 nm und 600 nm, bevorzugt zwischen 450 nm und 550 nm, besonders bevorzugt zwischen 520 nm und 540 nm, insbesondere bevorzugt 532 nm.

Das Verfahren der vorliegenden Erfindung benötigt keine zusätzlichen Inhaltsstoffe, sondern nutzt eine inhärente Eigenschaft des Photoinitiators. Im Falle der vorliegenden Erfindung absorbiert das Lacksystem das Abregungslicht nur dort, wo auch eine Anregung vorliegt. Dadurch kann das Abregungslicht tief in eine Probe hinein fokussiert werden. Somit können zusammen mit einer Mehrphotonenanregung dreidimensionale Strukturen, insbesondere mit verbesserter Auflösung, hergestellt werden.

Das Verfahren der vorliegenden Erfindung ist daher sowohl auf zweidimensionale als auch auf dreidimensionale Lithographie anwendbar.

Das Verfahren der vorliegenden Erfindung benutzt etablierte, kommerziell erhältliche Komponenten und ist somit sehr ökonomisch, da die Komponenten leicht erhältlich sind.

Die Verwendung der genannten photodeaktivierbaren Photoinitiatoren hat den Vorteil, dass diese im UV-Bereich, bevorzugt bei 300 - 450 nm absorbieren, so dass gängige UV-Belichtungsverfahren angewandt werden können. Das Prozessieren der Proben kann unter Gelblicht oder Rotlicht durchgeführt werden.

Die aus dem erfindungsgemäßen Verfahren resultierenden Strukturen sind im sichtbaren Spektralbereich transparent und können somit uneingeschränkt für die Herstellung nanooptischer Devices eingesetzt werden.

Es ist im Rahmen der vorliegenden Erfindung unter anderem möglich eine sequentielle punktweise Belichtung mit fokussiertem Licht und Ein- oder Zwei-Photonen-Absorption zu benutzen. Genauso ist es beispielsweise möglich, auch für großflächige parallele Lithographie herkömmliche Ein-Photonen-Absorption anzuwenden. Dazu wird statt eines ringförmigen ("Doughnut"-förmigen) Fokus dann beispielsweise ein durch Interferenz erzeugtes Intensitätsgitter und dessen Nullstellen benutzt.

ITX wird im Stand der Technik oft zusammen mit Co-Initiatoren verwendet, und übernimmt dann die Rolle der Lichtabsorption, während der Co-Initiator dann für eine effizientere Initiierung sorgt. Der im Rahmen der vorliegenden Erfindung ausgenutzte Deaktivierungseffekt funktioniert auch in Kombination mit einem solchen Co-Initiator, gegebenenfalls ist die Wellenlänge des Deaktivierungslasers genauer anzupassen.

Auch bei Datenspeichern, die darauf basieren, in einem optischen Formkörper, also in einer Polymer-Matrix durch Laserlicht kleine Punkte stärker zu vernetzen und somit deren Brechungsindex zu verändern, können durch die vorliegende Erfindung kleinere Punkte und somit höhere Datendichten erreicht werden.

In einer Variante der vorliegenden Erfindung werden die Laserstrahlen zur Initiierung (Anregung) und Deaktivierung (Abregung) mit einem Strahlteiler kombiniert und zusammen durch ein Mikroskopobjektiv durch ein Deckglas in einen Tropfen des Fotolacks fokussiert. Da im Deaktivierungsstrahl vor dem Strahlteiler eine Phasenmaske eingesetzt wird, erzeugt dieser Strahl im Fokus des Objektivs ein Doughnut-förmiges Interferenzmuster mit einem tiefen Minimum in der Mitte. Die Strahlen werden so ausgerichtet, dass gerade um dieses Minimum der Fokus des Anregungslasers zentriert ist. So können im Fokus einzelne dreidimensional begrenzte Punkte polymerisiert werden. Durch ein Verschieben der Probe relativ zum Fokus können durch serielle Punktbelichtungen beliebige Strukturen erzeugt werden.

Das zusätzliche Einbringen des Abregungslasers verhindert die Polymerisation in der Peripherie des ansonsten beugungsbegrenzten Polymerisationsvolumens und verkleinert dadurch die Ausmaße des kleinsten herstellbaren Volumenelements.

In einer Variante der vorliegenden Erfindung werden An- und Abregungslaser getrennt voneinander fokussiert. Es ist im Rahmen der vorliegenden Erfindung z.B. möglich, einen Strahl von oben in den Lack bzw. Formkörper treten zu lassen und den anderen Strahl von unten oder schräg oben in den Lack bzw. Formkörper treten zu lassen. Wesentlich ist, dass die Strahlen sich im Fokuspunkt treffen.

Auch seitliches Eintreten der Strahlen in die Probe ist denkbar.

Selbstverständlich ist es nicht notwendig, durch ein Deckglas in Tropfen eines Lackes zu fokussieren. Es ist lediglich notwendig, dass der Lack in einer Entfernung vor dem Mikroskopobjektiv platziert ist, dass eine Fokussierung in ihn möglich ist. Genauso ist es möglich statt Tropfen größere Lackmengen zur Behandlung bereitzustellen. Dann ist lediglich ein größerer apparativer Aufwand zur Bewegung/Positionierung des Lackes notwendig, es lassen sich dann aber größere Strukturen erzeugen. Diese Varianten sind von der vorliegenden Erfindung umfasst.

In einer Variante der vorliegenden Erfindung wird statt einer herkömmlichen Anregung mit <450 nm eine Zwei-Photonen-Anregung mit Femtosekunden-Laserpulsen mit einer Zentralwellenlänge von 810 nm angewendet.

In einer Variante der vorliegenden Erfindung wird eine herkömmliche Anregung mit UV-Licht oder blauem Licht bis 450 nm durchgeführt.

Im Rahmen der vorliegenden Erfindung wurde gefunden, dass sich bei gleicher Anregungsleistung und Verfahrgeschwindigkeit durch zusätzliche Benutzung des Abregungslasers und gegebenenfalls einer Phasenmaske die Linienbreite beispielsweise von 130 nm auf 65 nm reduzieren ließ. Dies ist der Einengung der effektiven Anregung und teilweise der insgesamt verringerten Polymerisationsrate zuzuschreiben.

Schließlich ist auch Gegenstand der vorliegenden Erfindung ein Lithographielack für Verfahren zur optischen Lithographie unterhalb des Beugungslimits gemäß obiger Darstellung enthaltend oder bestehend aus
(i) einem oder mehreren polymerisierbaren Monomeren und
(ii) einem oder mehreren photodeaktiverbaren Photoinitiatoren ausgewählt aus der Gruppe bestehend aus Thioxanthonen, bevorzugt Isopropylthioxanthonen, und/oder Cumarinen, bevorzugt Cumarin-30, bis-(Di-N-alkylierten) Aminobenzophenonen, insbesondere Isopropylthioxanthone,
(iii) gegebenenfalls den oben genannten Lösemitteln.

In einer bevorzugten Variante besteht der Lithographielack aus
(i) einem oder mehreren polymerisierbaren Monomeren und
(ii) einem oder mehreren Isopropylthioxanthonen als photodeaktiverbaren Photoinitiator.

Ein solcher Lack, bei dem auf Co-Initiatoren zur Polymerisationsinitiierung verzichtet werden konnte, ist aus dem Stand der Technik bisher nicht bekannt.

Es ist ein großer Vorteil der vorliegenden Erfindung, dass die bisher unbekannte Photodeaktivierbarkeit eines kommerziellen etablierten Photoinitiators ausgenutzt wird, um kleinere Strukturen herstellen zu können.

Es können mittels der vorliegenden Erfindung räumlich kleinere Strukturen optisch hergestellt werden, als dies bisher möglich war.

Die Erfindung ist auf dem gesamten Gebiet der optisch-lithografischen Herstellung von kleinen und kleinsten Strukturen von großem Interesse. Sie kann ebenfalls zur Entwicklung von optischen Datenspeichern mit extrem hoher Datendichte verwendet werden.

Die vorliegende Erfindung findet Verwendung für Photolacksysteme für extrem hochauflösende Lithografie, für die bzw. in der Halbleiterindustrie im Allgemeinen, und für schnelle Prototypen-Herstellung für Mikrochips, sowie zur Herstellung optischer Bauelemente.

Die vorliegende Erfindung kann neben der Herstellung kleiner planarer oder dreidimensionaler Strukturen auch zum Beschreiben von optischen Datenspeichern hoher Dichte verwendet werden, da hier ähnliche Vernetzungsreaktionen verwendet werden können, und das Beugungslimit auf gleiche Weise umgangen werden kann.

Gegenstand der vorliegenden Erfindung ist auch die Verwendung von Thioxanthonen, bevorzugt Isopropylthioxanthone, und/oder Cumarinen, bevorzugt Cumarin-30, insbesondere Isopropylthioxanthone, als photodeaktivierbare Photoinitiatoren in Lacken zur optischen Lithographie unterhalb des Beugungslimits in obigem Verfahren.

Weiterhin ist Gegenstand der vorliegende Erfindung ein Verfahren zur Verkleinerung des Lithographiemaßstabs und/oder der Lithographieauflösung bei der optischen Lithographie durch Verwendung von Thioxanthonen, bevorzugt Isopropylthioxanthonen, und/oder Cumarinen, bevorzugt Cumarin-30, und/oder bis-(Di-N-alkylierten) Aminobenzophenonen, insbesondere Isopropylthioxanthonen in obigem Verfahren.

Durch die vorliegende Erfindung lassen sich lithographisch erzeugte Strukturen in Größenordnungen, in der Reihenfolge der Bevorzugung, hinunter bis zu 65 nm, bis zu 60 nm, bis zu 50 nm, bis zu 40 nm, bis zu 30 nm, bis zu 20 nm, bis zu 10 nm, bis zu 5 nm, bis zu 1 nm erstellen.

Eine besonders bevorzugte Variante der vorliegende Erfindung ist ein Verfahren zur optischen Lithographie unterhalb des Beugungslimits bei dem
a) ein Lack bestehend aus
   (i) mindestens einem polymerisierbaren Monomeren ausgewählt aus der Gruppe bestehend aus radikalisch oder kationisch polymerisierbaren Verbindungen, bevorzugt radikalisch polymerisierbaren Verbindungen, besonders bevorzugt (Meth)acrylaten und/oder anderen vinylischen Verbindungen, höchst bevorzugt Pentaerythritoltriacrylat und/oder ethoxyliertes (9) Trimethylolpropantriacrylat,
   (ii) mindestens einem photodeaktiverbaren Photoinitiator ausgewählt aus der Gruppe bestehend aus Thioxanthonen, bevorzugt Isopropylthioxanthonen, und/oder Cumarinen, bevorzugt Cumarin-30 und/oder bis-(Di-N-alkylierten) Aminobenzophenonen, insbesondere bevorzugt Isopropylthioxanthone,
   auf ein Substrat aufgebracht wird,
b) die Polymerisation durch Einstrahlung von Licht, bevorzugt eines Lasers, einer ersten, den Photoinitiator aktivierenden, Wellenlänge (Anregungslicht) an einem ausgewählten Ort initiiert wird, und gleichzeitig oder danach, bevorzugt gleichzeitig
c) die Polymerisation durch Einstrahlung von Licht, bevorzugt eines Lasers, einer zweiten, den Photoinitiator deaktivierenden, Wellenlänge (Abregungslicht) zwischen 400 und 600 nm, bevorzugt 520 und 540 nm, insbesondere 532 nm, in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt, dadurch gekennzeichnet, dass
als photodeaktivierbare Photoinitiatoren Thioxanthone und/oder Cumarine und/oder bis-(Di-N-alkylierte) Aminobenzophenone eingesetzt werden.

In einer Variante der vorliegenden Erfindung werden nur Thioxanthone, bevorzugt Isothioxanthone, insbesondere Isopropylthioxanthone eingesetzt.

In einer Variante der vorliegenden Erfindung werden nur Cumarine, insbesondere Cumarin 30 eingesetzt.

In einer Variante der vorliegenden Erfindung werden nur bis-(Di-N-alkylierte) Aminobenzophenone, bevorzugt 4,4'-Bis-(Dimethylamino)-benzophenon oder 4,4'-Bis-(Diethylamino)benzophenon, insbesondere 4,4'-bis-(Diethylamino)benzophenon eingesetzt.

Eine weitere Variante der vorliegende Erfindung ist ein Verfahren zur optischen Lithographie unterhalb des Beugungslimits bei dem
a) ein in einem gegebenen Lösemittel unlösliches Polymerisat enthaltend
   (i) mindestens ein Polymer
   (ii) mindestens einen photodeaktiverbaren Photoinitiator, bevorzugt wie oben beschrieben,
   (iia) mindestens einen Co-Initiator, bevorzugt wie oben beschrieben,
   auf ein Substrat aufgebracht wird,
b) eine Reaktion durch Einstrahlung von Licht, bevorzugt eines Lasers, einer ersten, den Photoinitiator aktivierenden, Wellenlänge (Anregungslicht) an einem ausgewählten Ort initiiert wird, und gleichzeitig oder danach
c) die Reaktion durch Einstrahlung von Licht, bevorzugt eines Lasers, einer zweiten, den Photoinitiator deaktivierenden, Wellenlänge (Abregungslicht) in der unmittelbaren Umgebung des ausgewählten Ortes unterdrückt wird,
wobei mit dem eingestrahlten Abregungslicht ein Interferenz-Muster erzeugt wird, welches an dem ausgewählten Ort ein Intensitätsminimum oder null Intensität besitzt, dadurch gekennzeichnet, dass
als photodeaktivierbare Photoinitiatoren Thioxanthone und/oder Cumarine und/oder bis-(Di-N-alkylierte) Aminobenzophenone eingesetzt werden, und wobei die Reaktion darin besteht, dass am ausgewählten Ort das Polymerisat derart verändert wird, bevorzugt durch Freisetzung einer Säure durch den Co-Initiator, dass es in dem gegebenen Lösemittel löslich wird.

In Zusammenhang mit dieser Variante um fasst der Begriff "unlöslich" auch "sehr schwer löslich", in dem Sinne, dass das Polymer bei längerer Gegenwart in dem Lösemittel ein wenig gelöst werden kann. Dieses Phänomen ist dem Fachmann bei Positiv-Lacken als Dunkelabtrag wohl bekannt, für die Dauer des Verfahrens nach dieser Variante jedoch ist das Polymer als unlöslich anzusehen, da in diesem Zeitraum nur extrem wenig Polymer gelöst wird. Da dem Fachmann dies gut bekannt ist, erübrigen sich hierzu nähere Ausführungen.

Dabei ist eine höchst bevorzugte Variante die, worin die jeweils am meisten bevorzugten Varianten kombiniert sind.

Bevorzugte Varianten der vorliegenden Erfindung sind demnach die folgenden Verfahren mit den angegebenen Varianten I) bis VIII):
Verfahren zur optischen Lithographie unterhalb des Beugungslimits bei dem
a) ein Lack enthaltend oder bestehend aus
   (i) mindestens einem polymerisierbaren Monomeren,
   (ii) einem photodeaktiverbaren Photoinitiator,
   (iia) gegebenenfalls mindestens einen Co-Initiator,
   (iii) gegebenenfalls ein Lösemittel oder Lösemittelgemisch,
   (iv) gegebenenfalls weiteren Hilfsstoffen,
   auf ein Substrat aufgebracht wird,
b) die Polymerisation durch Einstrahlung von Licht, bevorzugt eines Lasers, einer ersten, den Photoinitiator aktivierenden, Wellenlänge (Anregungslicht) an einem ausgewählten Ort initiiert wird, und gleichzeitig oder danach
c) die Polymerisation durch Einstrahlung von Licht, bevorzugt eines Lasers, einer zweiten, den Photoinitiator deaktivierenden, Wellenlänge (Abregungslicht) in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt, gekennzeichnet durch eine der Alternativen I) bis VIII)
I) als photodeaktiverbarer Photoinitiator ein Thioxanthon, bevorzugt Isopropylthioxanthon, eingesetzt wird, und der Abregungslaser eine Wellenlänge zwischen 400 und 600 nm aufweist,
II) als photodeaktiverbarer Photoinitiator ein Thioxanthon, bevorzugt Isopropylthioxanthon, eingesetzt wird, und der Abregungslaser ein Dauerstrichlaser (continuous wave, cw), bevorzugt mit einer Wellenlänge zwischen 400 und 600 nm, besonders bevorzugt mit einer Wellenlänge von 532 nm, ist,
III) als photodeaktiverbarer Photoinitiator ein Cumarin, bevorzugt Cumarin-30 eingesetzt wird,
IV) als photodeaktiverbarer Photoinitiator ein Cumarin, bevorzugt Cumarin-30 eingesetzt wird, und der Abregungslaser eine Wellenlänge zwischen 400 und 600 nm aufweist,
V) als photodeaktiverbarer Photoinitiator ein Cumarin, bevorzugt Cumarin-30 eingesetzt wird, und der Abregungslaser ein Dauerstrichlaser (continuous wave, cw), bevorzugt mit einer Wellenlänge zwischen 400 und 600 nm, besonders bevorzugt mit einer Wellenlänge von 532 nm, ist,
VI) als photodeaktiverbarer Photoinitiator ein bis-(Di-N-alkyliertes) Aminobenzophenon eingesetzt wird,
VII) als photodeaktiverbarer Photoinitiator ein bis-(Di-N-alkyliertes) Aminobenzophenon eingesetzt wird, und der Abregungslaser eine Wellenlänge zwischen 400 und 600 nm aufweist,
VIII) als photodeaktiverbarer Photoinitiator ein bis-(Di-N-alkyliertes) Aminobenzophenon eingesetzt wird, und der Abregungslaser ein Dauerstrichlaser (continuous wave, cw), bevorzugt mit einer Wellenlänge zwischen 400 und 600 nm, besonders bevorzugt mit einer Wellenlänge von 532 nm, ist.

Die verschiedenen Ausgestaltungen der vorliegenden Erfindung, z.B. - aber nicht ausschließlich - diejenigen der verschiedenen abhängigen Ansprüche, können dabei in beliebiger Art und Weise miteinander kombiniert werden.

Die Erfindung wird nun unter Bezugnahme auf die folgenden Figuren und nichtlimitierenden Beispiele erläutert.

In der Beschreibung und in den Zeichnungen sind gleiche Teile beziehungsweise Merkmale in Beschreibung und den Zeichnungen durch die gleichen Ziffern bezeichnet. Die Zeichnungen sind nicht unbedingt maßstabsgetreu. Aus Gründen der Klarheit und zur einfacheren Darstellung können einige Merkmale der Erfindung übertrieben groß oder in schematischer Form dargestellt sein, ebenso können demgemäß einige Details von konventionellen bzw. bekannten Elementen nicht dargestellt sein.

### Bezugszeichenliste:

- 1: Mikroskop
- 2: Anregungslaser
- 3: Abregungslaser
- 4: Akusto-optischer Modulator
- 5: optische Linsen
- 6: Phasenmaske
- 7: Strahlteiler
- 8: Objektivlinse
- 9: Piezoelektrische Verfahrbühne

Figur 1:
   a) Exemplarische beugungsbegrenzte Intensitätsverteilung des Anregungslasers. Oberhalb einer gewissen Schwell-Intensität (polymerization threshold) wird die Polymerisation gestartet.
   b) Mit einem zweiten Laser wird ein Interferenzmuster mit einem tiefen Minimum (hier null Intensität) um den Ort der Anregung erzeugt.
   c) das Abregungsmuster behindert die Polymerisation lokal entsprechend der lokalen Abregungsintensität. Am Ort der Nullstelle bleibt die volle Anregung erhalten. Eine höhere Abregungsintensität führt zu einer schmaleren resultierenden Anregungsverteilung. Diese ist nicht mehr beugungsbegrenzt.
Figur 2 zeigt Absorptions- und Fluoreszenz Spektren von ITX gemessen in Ethanol.
Figur 3 zeigt exemplarischen den Lithographischen Aufbau, wie er in dem Verfahren der vorliegenden Erfindung verwirklicht wird. Dabei werden die Laserstrahlen zur Anregung und Abregung mit einem Strahlteiler kombiniert und zusammen durch ein Mikroskopobjektiv durch ein Deckglas in einen Tropfen des Fotolacks fokussiert. Im Deaktivierungsstrahl vor dem Strahlteiler ist eine Phasenmaske eingesetzt. Der Fokus des Anregungslasers wird so ausgerichtet, dass er um das Minimum des Deaktivierungslasers zentriert ist. So können im Fokus einzelne dreidimensional begrenzte Punkte polymerisiert werden und durch den phasenmodulierten Abregungslaser deren Volumen verringert werden.
Figur 4 zeigt experimentell bestimmte Testlinien für unterschiedliche Anregungs- und Abregungsleistungen.

### Beispiel 1:

Als Lack wurde eine Mischung bestehend aus 99 Gew.-% Pentaerythritoltriacrylat (PETA) als radikalisch polymerisierbares Monomer und 1 Gew.-% Isopropylthioxanthon (ITX) als Photoinitiator verwendet.

Der Lack wurde auf einen Probenhalter aufgebracht und unter das Mikroskopobjektiv in den Fokus eines invertierten Mikroskops gebracht.

Dann wurde ein Anregungslaser mit einer Wellenlänge von 810 nm (gepulst mit 140 fs) und ein Abregungslaser mit einer Wellenlänge von 532nm eingestrahlt, wobei im Deaktivierungsstrahl vor dem Strahlteiler eine Phasenmaske eingesetzt war, so dass im Fokus des Objektivs ein Doughnut-förmiges Interferenzmuster mit einem tiefen Minimum in der Mitte erzeugt wurde. Der Fokus des Anregungslasers wurde um dieses Minimum zentriert.

Durch die Einstrahlung wurde eine Polymerisation im Fokus des Anregungslasers initiiert, die durch das Interferenzmuster des Abregungslasers räumlich enger begrenzt war.

Durch ein Verschieben der Probe relativ zum Fokus wurden Testlinien mit unterschiedlicher Anregungs- und Abregungsleistung hergestellt, wie dies in Figur 4 zu sehen ist. Ein sukzessives Erhöhen der Abregungsleistung führte zuerst zu einer Verringerung der Linienbreite, dann zu einem Ausbleiben der Polymerisation (wenn die resultierende Anregung unter die Polymerisationsschwelle des Lackes fällt).

### Beispiel 2:

Beispiel 1 wurde wiederholt, mit dem Unterschied, dass als Monomer ethoxyliertes (9) Trimethylolpropantriacrylat eingesetzt wurde.

Es wurde der gleiche Effekt beobachtet.

### Beispiele 3 und 4:

Die Beispiele 1 und 2 wurden wiederholt, mit dem Unterschied, dass als Photoinitiator Cumarin-30 verwendet wurde.

Es wurde ebenfalls der gleiche Effekt beobachtet.

### Beispiel 5:

Beispiele 1 und 2 wurden wiederholt, wobei 4,4'-Bis-(Diethylamino)-benzophenon eingesetzt wurde.

Es wurde ebenfalls der gleiche Effekt beobachtet.

### Vergleichsversuche:

Die Versuche 1 und 2 wurden wiederholt, wobei als Photoinitiatoren Irgacure 369 (2-Benzyl-2-dimethylamino-184-morpholinophenyl)-butanon-1), Irgacure 819 (Bis(2,4,6-trimethylbenzoyl)-phenylphosphinoxid), Irgacure 1800 (Mischung aus Bis(2,6-dimethoxybenzoyl)-2,4,4-trimethyl-pentylphosphinoxid und 1-Hydroxy-cyclohexyl-phenyl-keton, Darocur TPO (Diphenyl-(2,4,6-trimethylbenzoyl)-phosphinoxid) verwendet wurden.

Es wurde keinerlei Photodeaktivierbarkeit beobachtet.

## Patentansprüche

1. Verfahren zur optischen Lithographie unterhalb des Beugungslimits bei dem
a) ein Lack enthaltend oder bestehend aus
(i) mindestens einem polymerisierbaren Monomeren,
(ii) mindestens einem photodeaktiverbaren Photoinitiator,
(iia) gegebenenfalls mindestens einen Co-Initiator,
(iii) gegebenenfalls ein Lösemittel oder Lösemittelgemisch,
(iv) gegebenenfalls weiteren Hilfsstoffen,
auf ein Substrat aufgebracht wird,
b) die Polymerisation durch Einstrahlung von Licht, bevorzugt eines Lasers, einer ersten, den Photoinitiator aktivierenden, Wellenlänge (Anregungslicht) an einem ausgewählten Ort initiiert wird, und gleichzeitig oder danach
c) die Polymerisation durch Einstrahlung von Licht, bevorzugt eines Lasers, einer zweiten, den Photoinitiator deaktivierenden, Wellenlänge (Abregungslicht) in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt, **dadurch gekennzeichnet, dass**
als photodeaktivierbare Photoinitiatoren Thioxanthone und/oder Cumarine und/oder bis-(Di-N-alkylierte) Aminobenzophenone eingesetzt werden.

2. Verfahren nach Anspruch 1 **dadurch gekennzeichnet, dass** als photodeaktivierbare Photoinitiatoren Isopropylthioxanthone, und/oder Cumarin-30 und/oder bis-(Di-N-alkylierte) Aminobenzophenone, insbesondere Isopropylthioxanthone, eingesetzt werden.

3. Verfahren nach Anspruch 2 **dadurch gekennzeichnet, dass** der Deaktivierungslaser eine Wellenlänge zwischen 400 und 600 nm, bevorzugt zwischen 450 und 550 nm, besonders bevorzugt 520 und 540 nm, insbesondere 532 nm, aufweist und/oder der Abregungslaser ein Dauerstrichlaser (continuous wave, cw), bevorzugt mit einer Wellenlänge zwischen 400 und 600 nm, besonders bevorzugt mit einer Wellenlänge von 532 nm, ist.

4. Verfahren nach einem der Ansprüche 1 bis 3 **dadurch gekennzeichnet, dass** als Monomere radikalische oder kationisch polymerisierbare Verbindungen, bevorzugt radikalisch polymerisierbare Verbindungen, insbesondere (Meth)acrylate und/oder andere vinylische Verbindungen eingesetzt werden.

5. Verfahren nach einem der Ansprüche 1 bis 4 **dadurch gekennzeichnet, dass** als Monomere, bevorzugt ohne weitere Monomere, Pentaerythritoltriacrylat und/oder ethoxyliertes (9) Trimethylolpropantriacrylat eingesetzt werden.

6. Verfahren nach einem der Ansprüche 1 bis 5 **dadurch gekennzeichnet, dass** der Lack aus den Komponenten (i) und (ii) besteht.

7. Verfahren nach Anspruch 1 bei dem
a) ein Lack enthaltend oder bestehend aus
(i) mindestens einem polymerisierbaren Monomeren,
(ii) einem photodeaktiverbaren Photoinitiator,
(iia) gegebenenfalls mindestens einen Co-Initiator,
(iii) gegebenenfalls ein Lösemittel oder Lösemittelgemisch,
(iv) gegebenenfalls weiteren Hilfsstoffen,
auf ein Substrat aufgebracht wird,
b) die Polymerisation durch Einstrahlung von Licht, bevorzugt eines Lasers, einer ersten, den Photoinitiator aktivierenden, Wellenlänge (Anregungslicht) an einem ausgewählten Ort initiiert wird, und gleichzeitig oder danach
c) die Polymerisation durch Einstrahlung von Licht, bevorzugt eines Lasers, einer zweiten, den Photoinitiator deaktivierenden, Wellenlänge (Abregungslicht) in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt,
**gekennzeichnet durch** eine der Alternativen I) bis VIII)
I) als photodeaktiverbarer Photoinitiator ein Thioxanthon, bevorzugt Isopropylthioxanthon, eingesetzt wird, und der Abregungslaser eine Wellenlänge zwischen 400 und 600 nm aufweist,
II) als photodeaktiverbarer Photoinitiator ein Thioxanthon, bevorzugt Isopropylthioxanthon, eingesetzt wird, und der Abregungslaser ein Dauerstrichlaser (continuous wave, cw), bevorzugt mit einer Wellenlänge zwischen 400 und 600 nm, besonders bevorzugt mit einer Wellenlänge von 532 nm, ist,
III) als photodeaktiverbarer Photoinitiator ein Cumarin, bevorzugt Cumarin-30 eingesetzt wird,
IV) als photodeaktiverbarer Photoinitiator ein Cumarin, bevorzugt Cumarin-30 eingesetzt wird, und der Abregungslaser eine Wellenlänge zwischen 400 und 600 nm aufweist,
V) als photodeaktiverbarer Photoinitiator ein Cumarin, bevorzugt Cumarin-30 eingesetzt wird, und der Abregungslaser ein Dauerstrichlaser (continuous wave, cw), bevorzugt mit einer Wellenlänge zwischen 400 und 600 nm, besonders bevorzugt mit einer Wellenlänge von 532 nm, ist,
VI) als photodeaktiverbarer Photoinitiator ein bis-(Di-N-alkyliertes) Aminobenzophenon eingesetzt wird,
VII) als photodeaktiverbarer Photoinitiator ein bis-(Di-N-alkyliertes) Aminobenzophenon eingesetzt wird, und der Abregungslaser eine Wellenlänge zwischen 400 und 600 nm aufweist,
VIII) als photodeaktiverbarer Photoinitiator ein bis-(Di-N-alkyliertes) Aminobenzophenon eingesetzt wird, und der Abregungslaser ein Dauerstrichlaser (continuous wave, cw), bevorzugt mit einer Wellenlänge zwischen 400 und 600 nm, besonders bevorzugt mit einer Wellenlänge von 532 nm, ist.

8. Verfahren nach einem der Ansprüche 1 bis 7, wobei Lithographien in Größenordnungen, angegeben in der Reihenfolge der Bevorzugung, hinunter bis zu 65 nm, bis zu 60 nm, bis zu 50 nm, bis zu 40 nm, bis zu 30 nm, bis zu 20 nm, bis zu 10 nm, bis zu 5 nm, bis zu 1 nm erzeugt werden.

9. Verwendung des Verfahrens nach einem der Ansprüche 1 bis 8 für Photolacksysteme für extrem hochauflösende Lithografie, für die bzw. in der Halbleiterindustrie im Allgemeinen, für schnelle Prototypen-Herstellung für Mikrochips, zur Herstellung kleiner planarer oder dreidimensionaler Strukturen und zum Beschreiben von optischen Datenspeichern hoher Dichte, sowie zur Herstellung optischer Bauelemente.

10. Verfahren zur optischen Lithographie unterhalb des Beugungslimits bei dem
a) ein optischer Formkörper bereitgestellt wird,
b) eine Polymerisation durch Einstrahlung von Licht, bevorzugt eines Lasers, einer ersten, einen Photoinitiator aktivierenden, Wellenlänge an einem ausgewählten Ort initiiert wird, und gleichzeitig oder danach
c) die Polymerisation durch Einstrahlung von Licht, bevorzugt eines Lasers, einer zweiten, den Photoinitiator deaktivierenden, Wellenlänge in der unmittelbaren Umgebung des ausgewählten Ortes unterdrückt wird,
wobei
mit dem eingestrahlten Abregungslicht ein Interferenz-Muster erzeugt wird, welches an dem ausgewählten Ort ein Intensitätsminimum oder null Intensität besitzt, **dadurch gekennzeichnet, dass**
als photodeaktivierbare Photoinitiatoren Thioxanthone und/oder Cumarine und/oder bis-(Di-N-alkylierte) Aminobenzophenone eingesetzt werden.

11. Verfahren zur optischen Lithographie unterhalb des Beugungslimits bei dem
a) ein in einem gegebenen Lösemittel unlösliches Polymerisat enthaltend
(i) mindestens ein Polymer
(ii) mindestens einen photodeaktiverbaren Photoinitiator
(iia) mindestens einen Co-Initiator
auf ein Substrat aufgebracht wird,
b) eine Reaktion durch Einstrahlung von Licht, bevorzugt eines Lasers, einer ersten, den Photoinitiator aktivierenden, Wellenlänge (Anregungslicht) an einem ausgewählten Ort initiiert wird, und gleichzeitig oder danach
c) die Reaktion durch Einstrahlung von Licht, bevorzugt eines Lasers, einer zweiten, den Photoinitiator deaktivierenden, Wellenlänge (Abregungslicht) in der unmittelbaren Umgebung des ausgewählten Ortes unterdrückt wird,
wobei mit dem eingestrahlten Abregungslicht ein Interferenz-Muster erzeugt wird, welches an dem ausgewählten Ort ein Intensitätsminimum oder null Intensität besitzt und
wobei die Reaktion darin besteht, dass am ausgewählten Ort das Polymerisat derart verändert wird, bevorzugt durch Freisetzung einer Säure durch den Co-Initiator, dass es in dem gegebenen Lösemittel löslich wird, **dadurch gekennzeichnet, dass**
als photodeaktivierbare Photoinitiatoren Thioxanthone und/oder Cumarine und/oder bis-(Di-N-alkylierte) Aminobenzophenone eingesetzt werden.

## Claims

1. Method for carrying out optical lithography below the diffraction limit, in which
a) a varnish, comprising or consisting of
(i) at least a polymerizable monomer,
(ii) at least a photodeactivable photoinitiator,
(iia) optionally at least a co-initiator
(iii) optionally a solvent or a mixture of solvents
(iv) optionally other expidients
is applied to a substrate,
b) the polymerization is initiated at a selected location by light irradiation, preferably a laser, of a first wavelength (excitation light), activating the photoinitiator, and simultaneously or thereafter
c) the polymerization is suppressed in the immediate vicinity of the selected location by light irradiation, preferably a laser, of a second wavelength (de-excitation light), deactivating the photoinitiator,
in which
an interference pattern is generated with the irradiated de-excitation light which at the selected location has an intensity minimum or zero intensity, **characterised in that**
thioxanthones and/or coumarins and/or bis-(Di-N-alcylated) aminobenzophenones are used as photodeactivable photoinitiators.

2. Method according to claim 1, **characterised in that** isopropyl thioxanthones and/or coumarin-30 and/or bis-(Di-N-alcylated) aminobenzophenones, in particular isopropylthioxanthones, are used as photodeactivable photoinitiators.

3. Method according to claim 2, **characterised in that** the deactivating laser has a wavelength of between 400 and 600 nm, preferably between 450 and 550 nm, more preferably 520 and 540 nm, in particular 532, and/or the de-excitation laser is a continuous wave laser (continuous wave, cw), preferably with a wavelength of between 400 and 600 nm, more preferably with a wavelength of 532 nm.

4. Method according to any of claims 1 to 3, **characterised in that** as monomers radically or cationically polymerizable compounds, in particular radically polymerizable compounds, in particular (meth)acrylates and/or other vinylic compounds are used.

5. Method according to any of claims 1 to 4, **characterised in that** pentaerythritoltriacrylate and/or ethoxylated (9) trimethylolpropantriacrylate are used as monomers, preferably without further monomers.

6. Method according to any of claims 1 to 5, **characterised in that** the varnish consists of components (i) and (ii).

7. Method according to claim 1,
in which
a) a varnish, comprising or consisting of
(i) at least a polymerizable monomer,
(ii) a photodeactivable photo initiator,
(iia) optionally at least a co-initiator
(iii) optionally a solvent of mixture of solvents
(iv) optionally other expidients
is applied to a substrate,
b) the polymerization is initiated at a selected location by irradiation of light, preferably a laser, of a first wavelength (excitation light), activating the photoinitiator, and simultaneously or thereafter
c) the polymerization is suppressed in the immediate vicinity of the selected location by irriadiation of light, preferably a laser, of a second wavelength (de-excitation light), deactivating the photoinitiator,
in which
an interference pattern is generated with the irradiated de-excitation light, which at the selected location has an intensity minimum or zero intensity,
**characterised by** one of the alternatives I) to VIII)
I) a thioxanthone, in particular isopropylthioxanthone, is used as photodeactivable photoinitiator and the de-excitation laser has a wavelength of between 400 and 600 nm.
II) a thioxanthone , in particular isopropylthioxanthone, is used as photodeactivable photoinitiator and the de-excitation laser is a continuous wavelength laser (continuous wave, cw) preferably between 400 and 600 nm, more preferably of a wavelength of 532 nm,
III) a coumarin, perferably coumarin-30, is used as photodeactivable photoinitiator.
IV) a coumarin, perferably coumarin-30, is used as photodeactivable photoinitiator. and the de-excitation laser has a wavelength of between 400 and 600 nm,
V) a coumarin, in particular coumarin-30, is used as photodeactivable photoinitiator and the de-excitation laser is a continuous wavelength laser (continuous wave, cw) preferably of between 400 and 600 nm, more preferably of a wavelength of 532 nm,
VI) bis-(Di-N-alcylated) aminobenzophenone is used as photodeactivable photoinitiator.
VII) bis-(Di-N-alcylated) aminobenzophenone is used as photodeactivable photoinitiator. and the de-excitation laser has a wavelength of between 400 and 600 nm,
VIII) bis-(Di-N-alcylated) aminobenzophenone is used as photodeactivable photoinitiator and the de-excitation laser is a continuous wavelength laser (continuous wave, cw) preferably of between 400 and 600 nm, more preferably of a wavelength of 532 nm,

8. Method according to any of claims 1 to 7, in which lithographies are generated in the orders of magnitude, indicated in the order of preference, down to 65 nm, to 60 nm, to 50 nm, to 40 nm, to 30 nm, to 10 nm, to 5nm, to 1 nm.

9. Use of the method according to any of claims 1 to 8 for photoresist systems for extremely high-resolution lithography for, respectively in the semiconductor industry in general, for the rapid prototype fabrication for microchips, for the production of small planar or three-dimensional structures and for the description of high density optical data storage media and for the production of optical components.

10. Method for carrying out optical lithography below the diffraction limit, in which
a) an optical form body is provided,
b) the polymerization is initiated at a selected location by irradiation of light, preferably a laser, of a first wavelength , activating the photoinitiator, and simultaneously or thereafter
c) the polymerization is suppressed in the immediate vicinity of the selected location by irradiation of light, preferably a laser, of a second wavelength , deactivating the photoinitiator
in which
an interference pattern is generated with the iraidiated de-excitation light which at the selected location has an intensity minimum or zero intensity, **characterised in that**
thioxanthones and/or coumarins and/or bis-(Di-N-alcylated) aminobenzophenones are used as photodeactivable photoinitiators.

11. Method for carrying out optical lithography below the diffraction limit, in which
a) an insoluble polymer in a given solvent, comprising
(i) at least a polymer,
(ii)at least a photodeactivable photoinitiator,
(iia) at least a co-initiator
is applied to a substrate,
b) a reaction is initiated at a selected location by irradiation of light, preferably a laser, of a first wavelength (excitation light), activating the photoinitiator, and simultaneously or thereafter
c) the reaction is suppressed in the immediate vicinity of the selected location by irradiation of light, preferably a laser, of a second wavelength (de-excitation light), deactivating the photoinitiator,
in which
an interference pattern is generated with the irradiated de-excitation light which at the selected location has an intensity minimum or zero intensity and
in which the reaction is such that at the selected location the polymer is changed such that it is soluble in the given solvent, preferably by release of an acid by the co-initiator,
**characterized in that**
thioxanthones and/or coumarins and/or bis-(Di-N-alcylated) aminobenzophenones, are used as photodeactivable photoinitiators.

## Revendications

1. Procédé de lithographie optique en dessous de la limite de diffraction , en lequel
a) un vernis, contenant ou étant constitué de
(i) au moins un monomère polymérisable,
(ii) au moins un photo-initiateur photodésactivable ,
(iia) éventuellement au moins un co-initiateur
(iii) éventuellement un solvant ou un mélange de solvants
(iv) éventuellement d'autres adjuvants
est appliqué sur un substrat,
b) la polymérisation est amorcé par irraditaion de lumière, de préférence d'un laser, d'une première longueur d'onde (lumière d'excitation), activant le photo-initiateur, à un endroit sélectionné ,et simultanément ou après
c) la polymérisation est amorcé par irradiation de lumière, de préférence d'un laser, d'une seconde longueur d'onde (lumière de désexcitation) a l'environnement immédiat de l'endroit sélectionné, désactivant le photo-initiateur,
en lequel
un motif d'interférence est généré par la lumière de désexcitation irradiée, que à l'endroit sélectionné a un minimum de l'intensité ou aucune intensité, **caractérisé en ce que**
des thioxanthones et/ou coumarines et/ou bis-(Di-N-alkylés) aminobenzophénones sont utilisés comme photo-initiateurs photodésactivables.

2. Procédé selon la revendication 1, **caractérisé en ce que** thioxanthones d 'isopropyle et/ou coumarine-30 et/ou bis-(Di-N-alkylés) aminobenzophénones, en particulier -thioxanthones d'isopropyl, sont utilisés comme photo-initiateurs as photodésactivables .

3. Procédé selon la revencidation 2, **caractérisé en ce que** le laser désactivant a une longueur d'onde d'entre 400 et 600 nm, de préférence d'entre 450 et 550 nm, plus particulièrement 520 et 540 nm, en particulier 532, et/ou le laser de désexcitation est un laser d'onde continuée, de préférence avec une longueur de l'onde d'entre 400 et 600 nm, plus particulièrement avec longueur d'onde de 532 nm.

4. Procédé selon l'une quelconque des revendication 1 à 3, **caractérisé en ce que** comme monomères , des composés polymérisables par voie radicalaire ou cationique, en particulier des composés polymérisables par voie radicalaire , en particulier des composés (méth)acrylates et/ou d 'autres composés vinyliques sont utilisées.

5. Procédé selon l'une des revendications 1 to 4, **caractérisé en ce que** triacrylate de pentaérythritol et/ou des triacrylates de triméthylolpropane éthoxylé sont utilisé comme monomères, de préférence sans d'autres monomères.

6. Procédé selon l'une quelconque des revendications 1 to 5, **caractérisé en ce que** le vernis est constitué des composés (i) (ii).

7. Procédé selon la revendication 1, en lequel
a) un vernis, contenant ou étant constitué de
(i)au moins un monomère polymérisable,
(ii)au moins un photo-initiateur photodésactivable ,
(iia) éventuellement au moins un co-initiateur
(iii)éventuellement un solvant ou un mélange de solvants
(iv)éventuellement autres adjuvants
est appliqué sur un substrat,
b) la polymérisation est amorcé par irradiation de lumière, de préférence d'un laser, d'une première longueur d'onde (lumière d'excitation), activant le photo-initiateur, à un endroit sélectionné ,et simultanément ou après
c) la polymérisation est amorcé par irradiation de lumière, de préférence d'un laser, d'une seconde longueur d'onde (lumière de désexcitation), désactivant le photo-initiateur, à l'environnement immédiat de l'endroit sélectionné,
en lequel
un motif d'interférence est généré par la lumière projectée de désexcitation que à l endroit sélectionné a un minimum de l'intensité ou aucune intensité, **caractérisé par** l'une des alternatives I) à VIII)
I) un thioxanthone, en particulier thioxanthone d' isopropyle, est utilisé comme photoinitiateur photodésactivable et le laser de désexcitation a une longueur d'onde d'entre 400 et 600 nm.
II) un thioxanthone, en particulier thioxanthone d'isopropyle, est utilisé comme photoinitiateur photodésactivable et le laser de désexcitation est un laser à onde continue avec une longueur d 'onde de préférence d'entre 400 et 600, plus particulièrement d 'une longueur d'onde de 532 nm,
III) un coumarine, de préférence coumarine -30, est utilisé comme photo-initiateur photodésactivable.
IV) un coumarine, en particulier coumarine-30, est utilisé comme photoinitiateur photodésactivable et le laser de désexcitation a une longueur d'onde d'entre 400 et 600 nm.
V) un coumarine, en particulier coumarine-30, est utilisé comme photoinitiateur photodésactivable et le laser de désexcitation est un laser à onde continue.avec une longueur d'onde de préférence d'entre 400 et 600 , plus particulièrement d'une longueur d'onde de 532 nm,
VI) bis-(Di-N-alkylé) aminobenzophénone est utilisé comme photo-initiateur photodésactivable.
VII) bis-(Di-N-alkylé) aminobenzophénone est utilisé comme photoinitiateur photodésactivable et le laser de désexcitation a une longueur d'onde d'entre 400 et 600 nm.
VIII) bis-(Di-N-alkylé) aminobenzophénone est utilisé comme photoinitiateur photodésactivable et le laser de désexcitation est un laser à onde continue .avec une longueur d'onde de préférence d'entre 400 et 600, plus particulièrement d'une longueur d'onde de 532 nm,

8. Procéde selon l'une quelconque des revendications 1 to 7, en lequel des lithographies sont générés en ordres des magnitudes, indiqués en ordre de préférence vers de bas à 65 nm, à 60 nm, à 50 nm, à 40 nm, à 30 nm, à 10 nm, à 5nm, à 1 nm.

9. Utilisation du procédé selon l'une quelconque des revendications 1 à 8 pour des systèmes photoresistes pour la lithographie à résolution extrèmement haute, respectivement dans l'industrie semiconducteur en général, pour la production rapide de prototype pour des micro-puces, pour la production des structures planes ou trisdimensionelles et pour la description pour des mémoires de données optiques à haute densité.

10. Procédé de lithographie optique en dessous de la limite de diffraction , en lequel
a) un corps moulé optique est mis à disposition,
b) la polymérisation est amorcé par irradiation de lumière, de préférence d'un laser, d'une première longueur d'onde, activant le photo-initiateur, à un endroit sélectionné, et simultanément ou après
c) la polymérisation est amorcé par irradiation de lumière, de préférence d'un laser, d'une seconde longueur d'onde, à l'environnement immédiat de l'endroit sélectionné, désactivant le photo-initiateur,
en lequel
un motif d'interférence est généré par la lumière de désexcitation irradiée, que à l endroit sélectionné a un minimum de l'intensité ou aucune intensité, **caractérisé en ce que**
des thioxanthones et/ou coumarines et/ou bis-(Di-N-alkylés) aminobenzophénones sont utilisés comme photo-initiateurs photodésactivables.

11. Procédé de lithographie optique en dessous de la limite de diffraction , en lequel
a) un polymère non soluble, dans un solvant donné,
contenant
(i)au moins un polymère ,
(ii)au moins un photo-initiateur photodésactivable ,
(iia) au moins un co-initiateur
est appliqué sur un substrat
(b) la polymérisation est amorcé par irradation de lumière, de préférence d'un laser, d'une première longueur d'onde (lumière d'excitation), activant le photo-initiateur, à un endroit sélectionné , et simultanément ou après
(c) la polymérisation est amorcé par irradiation de lumière, de préférence d'un laser, d'une seconde longueur d'onde (lumière de désexcitation), à un environnement immédiat de l'endroit sélectionné, désactivant le photo-initiateur,
en lequel
un motif d'interférence est généré par la lumière désexcitation irradiée, que à l'endroit sélectionné a un minimum de l'intensité ou aucune intensité, et
la réaction est qu'à l'endroit sélectionné le polymère est changé de manière, de prérérence par libération d'acide du co-initiateur, qu'est soluble dans le solvant donné, **caractérisé en ce que**
des thioxanthones et/ou coumarines et/ou bis-(Di-N-alkylés) aminobenzophénones sont utilisés comme photo-initiateurs photodésactivables.
